(19) Europäisches Patentamt / European Patent Office / Office européen des brevets

(11) **EP 3 674 998 B1**

(12) **FASCICULE DE BREVET EUROPEEN**

(45) Date de publication et mention de la délivrance du brevet:
**09.04.2025 Bulletin 2025/15**

(21) Numéro de dépôt: **19219566.7**

(22) Date de dépôt: **23.12.2019**

(51) Classification Internationale des Brevets (IPC):
**G06N 10/20** (2022.01)   **G06N 5/01** (2023.01)

(52) Classification Coopérative des Brevets (CPC):
**G06N 5/01; G06N 10/20**

(54) **MÉTHODE DE DÉVELOPPEMENT D'UN PROCÉDÉ DE COMPILATION D'UN CIRCUIT QUANTIQUE SUR UN PROCESSEUR QUANTIQUE**

ENTWICKLUNGSMETHODE EINES KOMPILIERUNGSVERFAHRENS EINES QUANTENSCHALTKREISES AUF EINEM QUANTENPROZESSOR

METHOD FOR THE DEVELOPMENT OF A METHOD FOR COMPILATION OF A QUANTUM CIRCUIT ON A QUANTUM PROCESSOR

(84) Etats contractants désignés:
AL AT BE BG CH CY CZ DE DK EE ES FI FR GB GR HR HU IE IS IT LI LT LU LV MC MK MT NL NO PL PT RO RS SE SI SK SM TR

(30) Priorité: **26.12.2018 FR 1874178**

(43) Date de publication de la demande:
**01.07.2020 Bulletin 2020/27**

(73) Titulaire: **Bull SAS**
**78340 Les Clayes-sous-Bois (FR)**

(72) Inventeurs:
• **GAZDA, Arnaud**
**95870 BEZONS (FR)**
• **MARTIEL, Simon**
**95870 BEZONS (FR)**

(74) Mandataire: **Plasseraud IP**
**104 Rue de Richelieu**
**CS92104**
**75080 Paris Cedex 02 (FR)**

(56) Documents cités:
• ALWIN ZULEHNER ET AL: "Compiling SU(4) ) antum Circuits to IBM QX Architectures", CORR (ARXIV), vol. 1808.05661, no. v2, 5 November 2018 (2018-11-05), pages 1 - 6, XP055637837

• THOMAS HÄNER ET AL: "A software methodology for compiling quantum programs", QUANTUM SCIENCE AND TECHNOLOGY, vol. 3, no. 2, 21 February 2018 (2018-02-21), pages 020501, XP055612173, DOI: 10.1088/2058-9565/aaa5cc

• MASLOV D ET AL: "Quantum Circuit Simplification and Level Compaction", ARXIV.ORG, CORNELL UNIVERSITY LIBRARY, 201 OLIN LIBRARY CORNELL UNIVERSITY ITHACA, NY 14853, 27 February 2008 (2008-02-27), XP080235665, DOI: 10.1109/TCAD.2007.911334

• ZULEHNER ALWIN ET AL: "Efficient mapping of quantum circuits to the IBM QX architectures", 2018 DESIGN, AUTOMATION & TEST IN EUROPE CONFERENCE & EXHIBITION (DATE), EDAA, 19 March 2018 (2018-03-19), pages 1135 - 1138, XP033334072, DOI: 10.23919/DATE.2018.8342181

• GUSHU LI ET AL: "Tackling the Qubit Mapping Problem for NISQ-Era Quantum Devices", ARXIV.ORG, CORNELL UNIVERSITY LIBRARY, 201 OLIN LIBRARY CORNELL UNIVERSITY ITHACA, NY 14853, 7 September 2018 (2018-09-07), XP081080306

• ESTEBAN A MARTINEZ ET AL: "Compiling quantum algorithms for architectures with multi-qubit gates", NEW JOURNAL OF PHYSICS, INSTITUTE OF PHYSICS PUBLISHING, BRISTOL, GB, vol. 18, no. 6, 24 June 2016 (2016-06-24), pages 63029, XP020304457, ISSN: 1367-2630, [retrieved on 20160624], DOI: 10.1088/1367-2630/18/6/063029

- MONA ARABZADEH ET AL: "Rule-based optimization of reversible circuits", DESIGN AUTOMATION CONFERENCE (ASP-DAC), 2010 15TH ASIA AND SOUTH PACIFIC, IEEE, PISCATAWAY, NJ, USA, 18 January 2010 (2010-01-18), pages 849 - 854, XP031641265, ISBN: 978-1-4244-5765-6
- SUMEET KHATRI ET AL: "Quantum-assisted quantum compiling", ARXIV.ORG, CORNELL UNIVERSITY LIBRARY, 201 OLIN LIBRARY CORNELL UNIVERSITY ITHACA, NY 14853, 2 July 2018 (2018-07-02), XP081202876

- WILL FINIGAN ET AL: "Qubit Allocation for Noisy Intermediate-Scale Quantum Computers", ARXIV.ORG, CORNELL UNIVERSITY LIBRARY, 201 OLIN LIBRARY CORNELL UNIVERSITY ITHACA, NY 14853, 19 October 2018 (2018-10-19), XP081067707

**Description**

**Domaine technique**

L'invention relève du domaine des méthodes de développement d'un procédé de compilation d'un circuit quantique sur un processeur quantique et des procédés de compilation d'un circuit quantique sur un processeur quantique.

**Technique antérieure**

Il est connu du document *Compiling SU(4) Quantum Circuits to IBM QX Architectures* une méthode permettant de compiler un programme quantique sur un processeur quantique fixé. La méthode ne considère que certains changements comme l'insertion de portes quantiques de permutation de valeur entre deux qbits et une décomposition de Cartan. La méthode cherche à minimiser le nombre de portes quantiques dans le circuit quantique résultant, en utilisant une heuristique.

Toutefois, cette méthode ne permet pas de compiler n'importe quel programme quantique sur n'importe quel processeur quantique. De plus, cette méthode n'est pas une méthode « à tout moment » (ou « anytime » en anglais), c'est-à-dire une méthode qui peut être arrêtée en cours de déroulement, sans perdre l'optimisation déjà réalisée.

Il est également connu du document *Rule-based optimization of reversible circuits* une méthode permettant de remplacer des sous-circuits quantiques par des sous-circuits quantiques équivalents optimaux.

Toutefois, cette méthode ne s'applique que pour des sous-circuits réversibles, présentant ainsi des contraintes importantes.

Des exemples et modes de réalisation de l'art antérieur peuvent être trouvés dans Alwin Zulehner et al : « Compiling SU(4) Quantum Circuits to IBM QX Architectures », CORR (ARXIV), vol. 1808.05661, no. v2, 5 novembre 2018, pages 1-6 ; Thomas Häner et al : « A software methodology for compiling quantum programs », Quantum Science and Technology, vol. 3, no. 2, 21 février 2018, 020501 ; Sumeet Khatri et al : « Quantum-assisted quantum compiling », ARXIV.ORG, Cornell University Library, 201 Olin Library Cornell University Ithaca, NY 14853, 2 juillet 2018 ; et Will Finigan et al : « Qubit Allocation for Noisy Intermediate-Scale Quantum Computers », ARXIV.ORG, Cornell University Library, 201 Olin Library Cornell University Ithaca, NY 14853, 19 octobre 2018.

**Problème technique**

Ces solutions connues ne permettent pas d'une part, de proposer une méthode capable de compiler un circuit quantique quelconque sur un processeur quantique quelconque, et, d'autre part, de permettre, lors de la compilation d'un circuit quantique, de proposer une méthode d'optimisation du circuit quantique qui fonctionne avec plusieurs métriques d'optimisation différentes.

L'invention vient pallier au moins partiellement les inconvénients de l'art antérieur.

Pour cela, l'invention propose une méthode permettant la compilation de tout circuit quantique sur tout processeur quantique, tout en permettant l'optimisation de la compilation du circuit quantique. Pour cela, il va être intéressant de proposer une étape de sélection d'une pluralité de paramètres comprenant le circuit quantique, le processeur quantique, une métrique d'optimisation et une heuristique ou une métaheuristique permettant l'optimisation de la compilation. Ainsi, la méthode est adaptable en termes de choix de compilation mais également en termes de choix d'optimisation de la compilation.

La méthode permet notamment une optimisation de la compilation en transformant le circuit quantique de sorte qu'il ne contient que des sous-circuits quantiques optimaux n'utilisant que des portes quantiques exécutables réduisant le nombre de portes quantiques utilisées afin de réduire la taille du circuit quantique obtenu tout en garantissant son fonctionnement, mais également en réduisant le nombre de portes quantiques de permutation entre qubits afin d'améliorer l'efficacité du circuit quantique obtenu. La méthode selon l'invention est apte à faire cette double optimisation en utilisant la même heuristique ou la même métaheuristique, de sorte que l'efficacité de la méthode est grandement améliorée.

Il est proposé une méthode selon la revendication 1.

Par « porte quantique efficace », on entend que la porte quantique peut être exécutée sur le processeur quantique ou qu'elle correspond à une opération quantique autorisée par le processeur quantique sélectionné. Par « porte quantique inefficace », on entend une porte quantique qui ne peut pas être exécutée par le processeur quantique ou qui ne correspond pas à une opération quantique autorisée par le processeur quantique sélectionné.

De préférence, une étape de détermination des qbits logiques sur les qbits physiques du processeur quantique sélectionné comprend :

- une boucle d'itérations comprenant successivement :

  * une étape de simulation d'une implémentation donnée des qbits logiques sur les qbits physiques du processeur quantique,
  * une étape de détection, dans le circuit quantique, de la ou des portes quantiques inefficaces,
  * une étape d'estimation du nombre de portes quantiques de permutation de valeur entre deux qbits physiques à insérer dans le circuit quantique pour que toutes les portes quantiques du circuit quantique soient, c'est-à-dire restent ou deviennent, des portes quantiques efficaces,
  * une étape de rétroaction, par l'intermédiaire de l'heuristique ou de la métaheuristique sélectionnée, entraînant une nouvelle étape de simulation en fonction du nombre de portes quantiques de permutation de valeur entre deux qbits physiques estimées, jusqu'à atteindre, lorsque toutes les portes quantiques sont efficaces :

    ° soit un seuil minimal du nombre de portes quantiques estimées de permutation de valeur entre deux qbits physiques,
    ° soit un seuil maximal d'itérations dans la boucle.

Ainsi, l'utilisation d'une boucle d'itérations lors de l'application de l'heuristique ou de la métaheuristique permet de pouvoir effectuer des désoptimisations locales pour obtenir finalement une optimisation globale du circuit quantique. Autrement dit, l'heuristique ou la métaheuristique se permet de ne pas effectuer des optimisations locales aveugles, optimisations locales risquant finalement de ne pas mener au circuit quantique le plus optimal. Ainsi, en choisissant parfois d'augmenter localement la métrique au lieu de la réduire systématiquement, l'heuristique ou la métaheuristique, mène à une optimisation globale du circuit quantique plus importante.

De préférence, le seuil maximal d'itérations dans la boucle est prédéterminé en fonction au moins du processeur quantique et/ou du circuit quantique sélectionnés.

Cela permet de limiter le nombre d'itérations lorsqu'un seuil de la métrique est atteint. Par ailleurs, la méthode étant une méthode « anytime », il est possible d'interrompre la boucle d'itérations à tout moment tout en obtenant un circuit quantique optimisé.

**Brève description des dessins**

D'autres caractéristiques, détails et avantages de l'invention apparaîtront à la lecture de la description détaillée ci-après, et à l'analyse des dessins annexés, sur lesquels :

**Fig. 1**

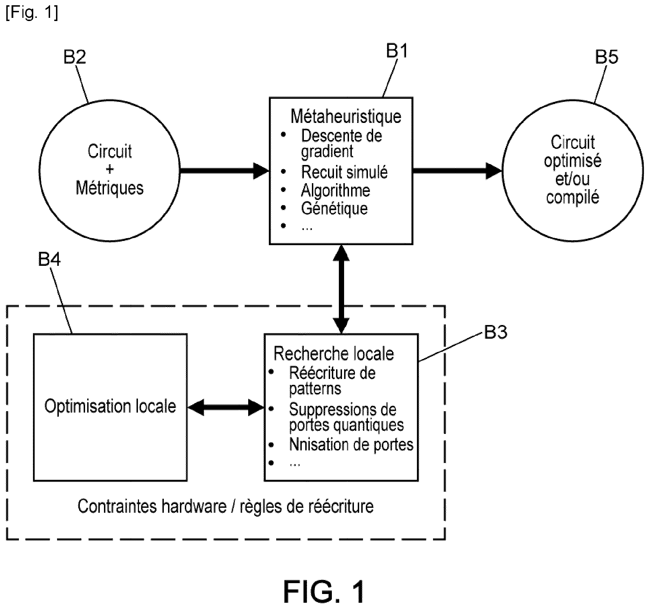

[Fig. 1] illustre un schéma bloc mis en œuvre par la méthode et le procédé de compilation d'un circuit quantique sur un processeur quantique selon un mode de réalisation de l'invention.

**Fig. 2a**

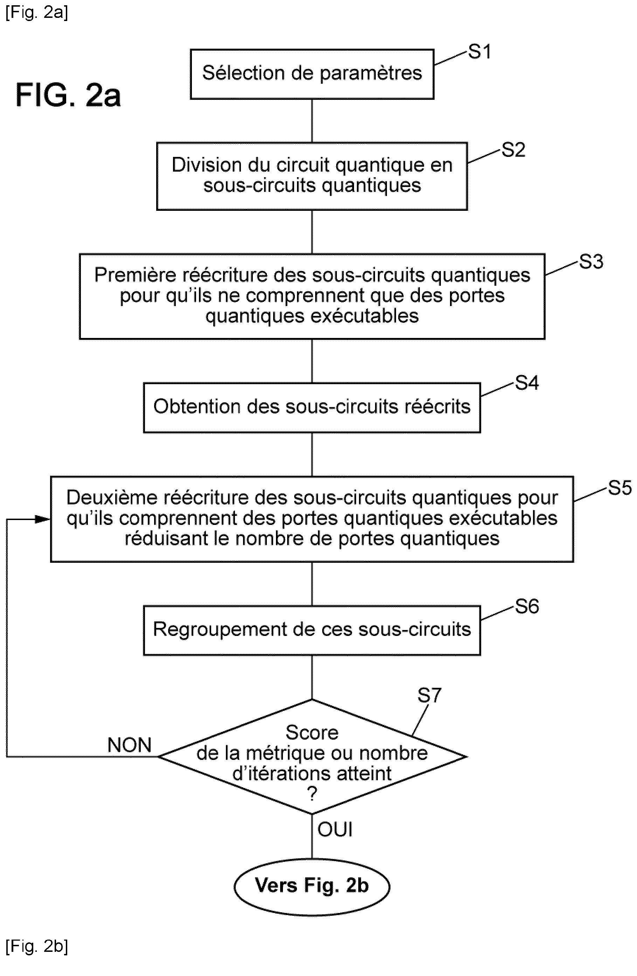

[Fig. 2a] illustre les principales étapes de la méthode et du procédé de compilation d'un circuit quantique sur un processeur quantique selon un mode de réalisation de l'invention.

**Fig. 2b**

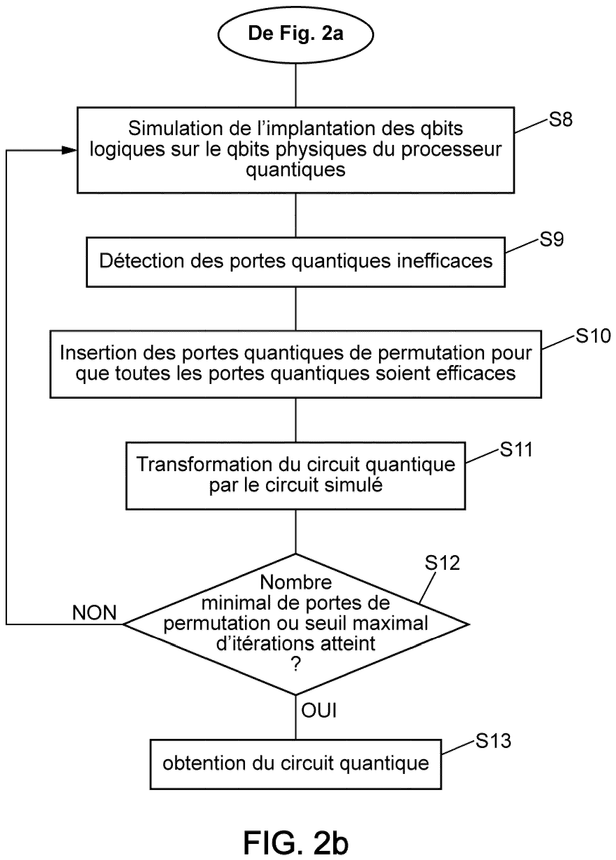

[Fig. 2b] illustre les principales étapes de la méthode et du procédé de compilation d'un circuit quantique sur un processeur quantique selon un mode de réalisation de l'invention.

**Fig. 3**

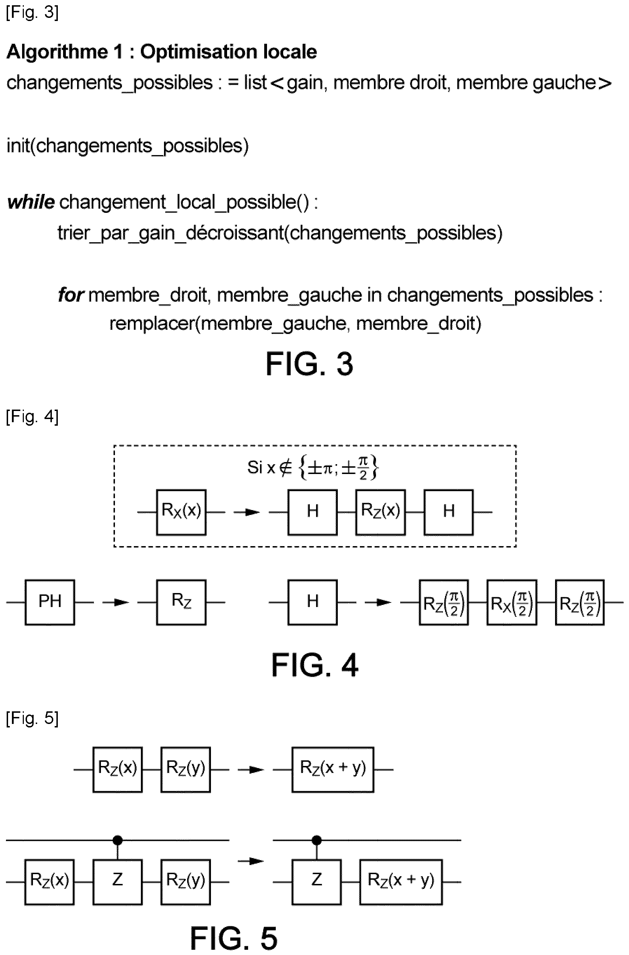

[Fig. 3] montre un pseudo code utilisé pour l'optimisation locale d'un circuit quantique selon la méthode et le procédé de compilation d'un circuit quantique sur un processeur quantique selon un mode de réalisation de l'invention.

**Fig. 4**
[Fig. 4] montre un exemple de règles utilisées pour la réécriture d'un circuit quantique selon la méthode et le procédé de compilation d'un circuit quantique sur un processeur quantique selon un mode de réalisation de l'invention.

**Fig. 5**
[Fig. 5] montre un exemple de règles utilisées pour la réécriture d'un circuit quantique selon la méthode et le procédé de compilation d'un circuit quantique sur un processeur quantique selon un mode de réalisation de l'invention.

**Fig. 6**

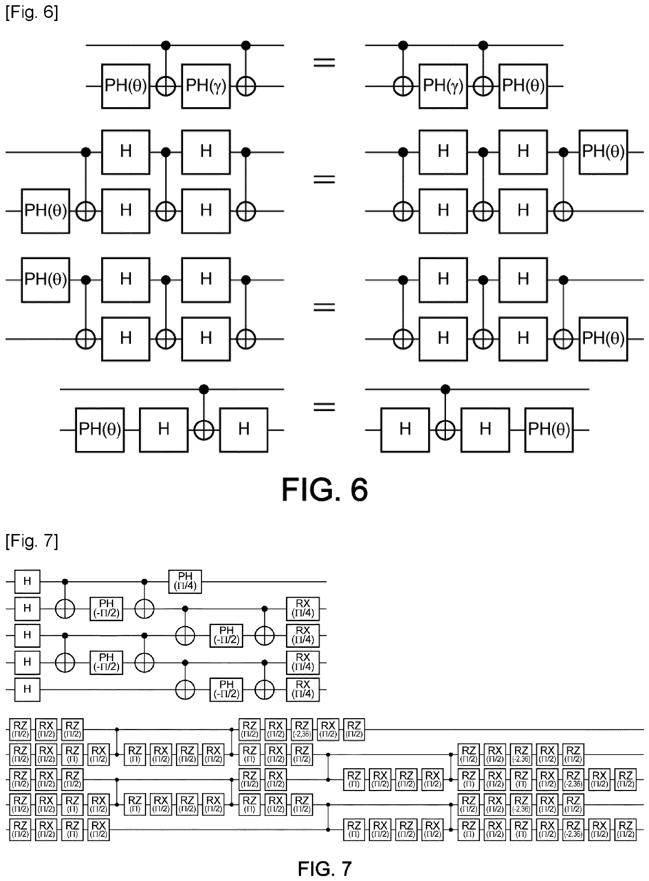

[Fig. 6] montre un exemple de règles utilisées pour la réécriture d'un circuit quantique selon la méthode et le procédé de compilation d'un circuit quantique sur un processeur quantique selon un mode de réalisation de l'invention

**Fig. 7**

[Fig. 7] montre un exemple de circuit quantique compilé à partir d'un circuit original selon un exemple de règles utilisées pour la réécriture d'un circuit quantique selon la méthode et le procédé de compilation d'un circuit quantique sur un processeur quantique selon un mode de réalisation de l'invention.

**Fig. 8**

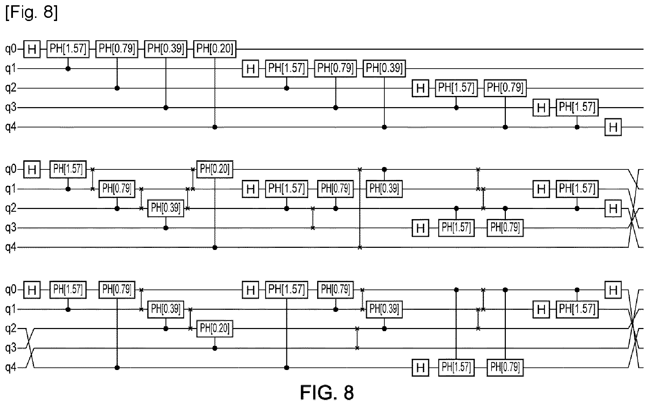

[Fig. 8] montre un autre exemple de circuit quantique compilé à partir d'un circuit original selon un exemple de règles utilisées pour la réécriture d'un circuit quantique selon la méthode et le procédé de compilation d'un circuit quantique sur un processeur quantique selon un mode de réalisation de l'invention.

**Description des modes de réalisation**

Il est maintenant fait référence à la figure 1. La méthode selon l'invention permet de compiler tout circuit quantique sur tout processeur quantique.

Pour ce faire, il s'agit de résoudre le problème suivant :

[Math. 1]

$$\underset{C' \sim_R C}{\mathrm{argmax}}\, f(C')$$

Où f est une métrique sélectionnable et $\sim_R$ est une relation binaire telle que :

[Math. 2]

$$C' \sim_R C \Leftrightarrow \text{"}C' \text{ peut être obtenu à partir de } C \text{ par changement locaux}$$

Une transformation $\rightarrow_L$ peut en outre être définie, telle que :

[Math. 3]

$$\rightarrow_L : \mathcal{C} \rightarrow \mathcal{P}(\mathcal{C})$$

Avec $C$ un ensemble de circuits quantiques.

Le problème peut donc être réécrit tel que

[Math. 4]

$$\underset{C'}{\mathrm{argmax}}\, \{f(C') \mid C \rightarrow_L^* C'\}.$$

La méthode selon l'invention permet de sélectionner la métrique f voulue, et des changements locaux $\rightarrow_L$ quelconques.

Plus précisément, les changements locaux permettent de définir des règles de réécriture du circuit quantique pour qu'il puisse être compilable sur un processeur quantique sélectionné. Les changements locaux sont par exemple un jeu de portes quantiques exécutables sur le processeur quantique sélectionné.

Les changements locaux peuvent en outre comprendre des règles d'optimisation, telles que l'insertion de portes quantiques de permutation, tel que décrit ci-après.

La méthode utilise notamment une heuristique ou une métaheuristique, illustrée par le bloc B1 de la figure 1.

L'heuristique ou la métaheuristique (ci-après appelée « métaheuristique ») est également sélectionnée. Notamment, la métaheuristique est sélectionnée parmi une descente de gradient, un recuit simulé ou encore un algorithme génétique.

La métaheuristique reçoit en entrée un circuit quantique sélectionné et une métrique globale, illustré par le bloc B2. La métrique globale peut notamment être sélectionnée pour diminuer le nombre de portes quantiques dans le circuit quantique compilable obtenu. La métaheuristique visse à maximiser la métrique globale sélectionnée.

Pour cela, la métaheuristique reçoit en outre en entrée des sous-circuits quantiques fournis par une recherche locale, correspondant au bloc B3.

La recherche locale reçoit elle-même en entrée le circuit quantique sélectionné. La recherche locale est apte à effectuer une séparation du circuit quantique en une pluralité de sous-circuits et de déterminer des sous-circuits quantiques équivalents.

Un sous-circuit quantique équivalent correspond à un sous-circuit quantique différent mais qui produit les mêmes effets, notamment en ce qui concerne des opérations quantiques.

Les sous-circuits équivalents sont déterminés en fonction des changements locaux autorisés, tels que des modifications de portes quantiques non exécutables par le processeur quantique sélectionné en portes quantiques exécutables par ce processeur quantique.

Plus précisément, la recherche locale B3 une opération de modification locale du circuit quantique. Plus précisément, un sous-circuit quantique est remplacé par un sous-circuit quantique équivalent sans considérer le circuit quantique dans sa globalité.

Cette modification est donc peu coûteuse au vue de la taille du circuit quantique.

A l'issu de cette modification, un nombre limité de sous-circuits est retourné à la métaheuristique, car la recherche locale B3 n'autorise que certains changements de sous-circuits, définis par les changements locaux sélectionnés. La recherche locale permet donc d"accélérer la métaheuristique.

Toutefois, ces réécritures du circuit quantique en sous-circuits quantiques équivalents peuvent mener à une dégradation de la métrique globale.

Ainsi, une optimisation locale peut être mise en œuvre par le bloc B4. L'optimisation locale détecte les sous-circuits quantiques non optimaux. Un sous-circuit quantique est non optimal s'il existe un sous-circuit quantique équivalent strictement meilleur. L'optimisation locale vise à remplacer les sous-circuits quantiques non optimaux par les sous-circuits quantiques optimaux.

L'optimisation locale utilise un score noté *l*. Pour un sous-circuit quantique, plus le score est élevé, plus le sous-circuit quantique est optimal.

Le circuit quantique est à modifier pour qu'il ne contienne que des sous-circuits optimaux tels que :

[Math. 5]

$$\forall\, C_1, C_2 \in \mathcal{C}^2, \text{if } C_1 \rightarrow_L C_2 \text{ and } l(C_1) \leq l(C_2) \text{ puis } C_1 \rightarrow C_2$$

L'opérateur $\rightarrow$ signifie remplacer les sous-circuits $C_1$ par $C_2$ dans tous les sous-circuits trouvés par la recherche locale.

L'optimisation locale effectue des changements locaux par gain décroissant. Autrement dit, les changements à gains élevés sont effectués en premier. Le gain est défini comme la différence de score entre un sous-circuit quantique et un sous-circuit quantique équivalent :

[Math. 6]

$$gain = score_{local}(membre\ droit) - score_{local}(membre\ gauche)$$

La figure 3 est un pseudo code utilisé pour la mise en œuvre de l'optimisation locale. Dans ce pseudo code, tous les changements locaux sélectionnés sont répertoriés. Pour chaque changement local sélectionné, les gains associé à la réécriture de chaque sous-circuit quantique par un sous-circuit quantique optimal sont calculés et triés afin d'effectuer en premier les réécritures dont le gain associé est le plus élevé.

Ces sous-circuits quantiques optimaux sont ensuite envoyés à la métaheuristique (bloc B2) qui réécrit le circuit quantique en remplaçant des sous-circuits quantiques par un sous-circuit quantique optimal dans le but de maximiser la métrique globale. Enfin, au bloc B5 le circuit quantique optimisé et compilé est obtenu.

Il est maintenant fait plus particulièrement référence aux figures 2a et 2b qui illustrent les principales étapes de la méthode et du procédé selon l'invention

Une étape de sélection S1 est d'abord mise en œuvre. Lors de l'étape de sélection S1, plusieurs éléments sont sélectionnés : un circuit quantique, un processeur quantique sur lequel compiler le circuit quantique sélectionné, un jeu de protes quantiques exécutables sur le processeur quantique sélectionné, une métrique à maximiser et une métaheuristique.

Dans l'exemple de réalisation qui suit, la métaheuristique sélectionnée est un recuit simulé.

Par ailleurs les métriques visent, d'une part, à réduire le nombre de portes quantiques global du circuit compilé, et, d'autre part, à réduire plus spécifiquement le nombre de portes quantiques de permutation à insérer dans le circuit quantique pour qu'il soit compilable.

Une étape de division S2 du circuit quantique en sous-circuits quantiques est ensuite effectuée.

Une première étape de réécriture S3 est mise en œuvre sur ces sous-circuits quantiques. Plus précisément, les sous-circuits quantiques comprenant des portes quantiques non exécutables par le processeur quantique sélectionné sont réécrits de manière à ce qu'ils comprennent uniquement des portes quantiques exécutables par le processeur quantique sélectionné.

Les sous-circuits quantiques réécrits sont ainsi obtenus à l'étape d'obtention S4.

La première étape de réécriture des sous-circuits quantiques est mise en œuvre par la recherche locale et l'optimisation locale illustrées par les blocs B3 et B4 de la figure 1.

Une deuxième étape de réécriture S5 des sous-circuits quantiques réécrits est ensuite effectuée. La deuxième étape de réécriture S5 est effectuée par le recuit simulé, et vise à maximiser la métrique globale, définie ici comme une minimisation du nombre de portes quantiques du circuit quantique.

A l'étape de regroupement S6, les sous-circuits quantiques sont regroupés pour obtenir un circuit quantique compilable par le processeur quantique. Autrement dit, toutes les portes quantiques présentes dans ce circuit quantique peuvent être exécutées par le processeur quantique.

Puis le recuit simulé détermine à l'étape de détermination S7 si les sous-circuits regroupés sont optimaux, c'est-à-dire que le score associé au circuit quantique obtenu à l'étape S6 atteint un seuil prédéterminé, ou si le nombre d'itérations maximal est atteint.

Si ce n'est pas le cas, la deuxième étape de réécriture S5 est de nouveau mise en œuvre afin d'optimiser encore le circuit quantique obtenu.

Les figures 4 à 6 illustrent un exemple de réécriture de sous circuits quantiques. Ainsi, des changements locaux sont définis tels que les sous-circuits quantiques (ou les portes quantiques) exécutables par le processeur et/ou les sous-circuits quantiques (ou les portes quantiques) que l'on souhaite conserver ont un score égal à zéro ou tout autre valeur constante. Les sous-circuits quantiques (ou les portes quantiques) non exécutables par le processeur et/ou les sous-circuits quantiques (ou les portes quantiques) que l'on souhaite voir disparaître ont un score égal à moins l'infini ou à toute autre valeur strictement inférieure au score des sous-circuits quantiques exécutables.

De plus, des combinaisons de portes quantiques exécutables par le processeur quantique peuvent être définies pour remplacer les portes quantiques non exécutables.

Par exemple, la figure 4 illustre un exemple dans lequel le processeur quantique sélectionné est apte à exécuter uniquement des portes quantiques à rotation selon l'axe Z Rz et selon l'axe X Rx. Ainsi, les portes quantiques à rotation selon l'axe X Rx peuvent être remplacées par une combinaison de portes quantiques de Hadamard H, à rotation selon l'axe Z Rz et de Hadamard. Une porte quantique PH peut être remplacée par une porte quantique à rotation selon l'axe Z Rz, etc. Sur la figure 4, tous les membres de gauche possèdent un score égal à moins l'infini et le membre de droite un score égal à zéro. Ainsi, tous les membres de gauche sont remplacés par les membres de droite lors de la première étape de réécriture S3.

Un autre exemple de règles est de changer l'ordre des portes quantiques, comme illustré sur la figure 6, où les portes quantiques sont les mêmes entre les sous-circuits à gauche et à droite de la figure, seules l'ordre des portes quantiques est modifié.

Par ailleurs, afin de respecter la métrique visant à réduire le nombre de portes quantiques, d'autres règles sont respectées. Par exemple, deux portes quantiques identiques qui se succèdent peuvent fusionner pour devenir une unique porte quantique, comme illustré sur la figure 5. Cela permet de maximiser la métrique sélectionnée.

Toutes ces règles sont appliquées par la recherche locale et l'optimisation locale, blocs B3 et B4 afin d'optimiser localement le circuit quantique. Toutefois, les sous-circuits réécrits sont retraités par le recuit simulé (bloc B1) qui, lui, cherche à optimiser la métrique globale du circuit, à savoir réduire le nombre de portes quantiques. Ainsi, lors de l'itération des étapes S5 à S7, le recuit simulé peut choisir de réécrire un sous-circuit diminuant la métrique locale du circuit mais maximisant la métrique globale du circuit quantique. L'utilisation du recuit simulé est donc particulièrement avantageuse.

.La figure 6 illustre un circuit quantique compilé optimisé, obtenu en sortie de l'étape de détermination S7. Ce circuit quantique comprend uniquement des portes quantiques exécutables par le processeur quantique sélectionné, soit des portes Rz et Rx, tandis qu'il comprenait initialement des portes quantiques H, CNOT et PH.

Une fois ce circuit quantique compilé et optimisé obtenu, une seconde optimisation peut être mise en œuvre.

Il s'agit de permettre de faire interagir des qubits entre eux. Pour ce faire, il est possible d'échanger la valeur de deux qubits afin de rapprocher les qubits à faire interagir, rendant ainsi l'interaction possible. Des portes de permutation quantique peuvent donc être ajoutées au circuit, afin d'échanger la valeur de deux qubits.

La métrique utilisée peut être modifié. Dans cet exemple, la métrique sélectionnée vise à obtenir un circuit quantique comprenant un minimum de portes quantiques de permutation.

A l'étape S8, la recherche locale (bloc B3) effectue une simulation de l'implémentation des qubits logiques du circuit quantique obtenu à l'étape S7 sur le qubits physiques du processeur quantique sélectionné.

A l'étape S9, cette même recherche locale détecte dans le circuit quantique les portes quantiques inefficaces. Par « inefficaces » on entend que les portes quantiques devant interagir entre deux qbits ne le peuvent pas car les qubits ne sont pas voisins, ou que ce sont des portes quantiques que l'on souhaite voir disparaître.

Une métrique locale peut alors être définie. Notamment le score local d'une porte quantique efficace est défini comme dépendant du nombre de portes quantiques de permutation insérées dans le circuit quantique. Le score peut donc être égal au nombre de portes quantiques de permutation présentes dans le circuit quantique. Une porte quantique agissant sur deux qbits non-voisins a un score local égal à moins l'infini ou strictement inférieur au score associé à une porte quantique efficace.

Cette métrique locale permet de garantir d'avoir un circuit quantique dont toutes les portes quantiques agissent sur deux qubits voisins, et donc que toutes les portes quantiques du circuit quantique sont efficaces.

Il est aussi possible de forcer la métrique locale à traiter les portes dans un ordre particulier (les premières portes en premier par exemple) en changeant légèrement la métrique locale.

De plus, il est possible d'améliorer la méthode en regardant l'impact de la simulation de l'étape de simulation S8 sur les qbits suivants.

Les règles de la métrique permettent de définir où les portes quantiques de permutation peuvent être insérées dans le circuit quantique. Le circuit quantique peut donc être transformé pour rapprocher les qbits d'une porte quantique, c'est à dire insérer une porte de permutation dans le circuit quantique et renuméroter les qubits du circuit quantique puisque les portes de permutation permutent l'ordre des qubits.

A l'étape d'insertion S10, les portes quantiques de permutation sont insérées dans le circuit quantique afin que toutes les portes quantiques du circuit soient efficaces. Une étape de transformation S11 du circuit quantique est ensuite mise en œuvre. Le recuit simulé effectue une optimisation globale du circuit pour respecter la métrique globale, à savoir minimiser le nombre de portes quantiques de permutation. Pour ce faire, des sous-parties du circuit quantique peuvent être réécrites, par exemple en suivant les règles de changements locaux autorisées par le processeur quantique, afin de supprimer des portes quantiques de permutation.

Les portes quantiques de permutation sont insérées par la recherche locale et l'optimisation locale, blocs B3 et B4, afin d'optimiser localement le circuit quantique, en supprimant toutes les portes quantiques inefficaces. Toutefois, le circuit quantique modifié est retraité par le recuit simulé qui, lui, cherche à optimiser la métrique globale du circuit, à savoir réduire le nombre de portes quantiques de permutation. Ainsi, lors de l'itération des étapes S8 à S11, le recuit simulé peut choisir de modifier des portes quantiques du circuit quantique, ce qui peut diminuer la métrique locale du circuit mais maximise finalement la métrique globale du circuit quantique. L'utilisation du recuit simulé est donc également particulièrement avantageuse.

Puis, à l'étape de détermination S12, si un nombre minimal de portes quantiques de permutation est atteint, ou si un nombre maximal d'itérations est atteint, le circuit quantique est retourné. Ce circuit quantique est compilable par le processeur quantique sélectionné et optimisé.

Si ce n'est pas le cas, la méthode est répétée depuis l'étape de simulation S8.

la figure 8 illustre le circuit quantique aux différentes étapes du circuit. Le premier circuit quantique correspond au circuit quantique obtenu à l'étape de simulation S8. Le deuxième circuit quantique est le circuit quantique obtenu après l'optimisation locale, c'est-à-dire après l'intégration des portes de permutation (étape d'insertion S10). Enfin, le dernier circuit quantique est obtenu après l'optimisation globale du circuit quantique par le recuit simulé qui permet de supprimer deux portes quantiques de permutation, lors de l'étape de transformation S11.

Le tableau ci-dessous illustre le résultat de la méthode selon l'invention dans le cas de la réduction du nombre de portes quantiques de permutation par rapport à un art antérieur, pour une application de transformation de Fourier quantique à 10, 13, 16, 20 qbits.

[Tableau 1]

| Méthodes | Art Antérieur | | Méthode selon l'invention | | |
|---|---|---|---|---|---|
| | Nombre de portes de permutation | Temps (s) | Nombre de portes de permutation | Temps (s) | Nombre de portes de permutation lorsque le procédé est arrêté à 10% du temps |
| QFT 10 | 54 | 0.103 | 20 | 3.52 | 27 |
| QFT 13 | 96 | 0.036 | 32 | 7.23 | 41 |
| QFT 16 | 186 | 0.084 | 62 | 19.32 | 82 |
| QFT 20 | 372 | 0.102 | 103 | 33.46 | 119 |

Il apparaît donc que la minimisation du nombre de portes de permutation avec la méthode selon l'invention est bien plus efficace que la méthode utilisée dans l'art antérieur. Par ailleurs, la méthode selon l'invention étant une méthode « anytime », la méthode peut être interrompue sans perdre l'optimisation déjà effectuée sur le circuit quantique, optimisation déjà bien plus efficace que la méthode de l'art antérieur, même à 10% du temps.

Toutefois, le circuit quantique obtenu comprend plus de portes quantiques que le circuit initial. Cela est dû notamment à l'insertion des portes quantiques de permutation. Il en résulte que les phénomènes de bruit sont amplifiés.

Une des sources de bruit est le temps d'inactivité des qbits.

Afin de réduire l'inactivité des qbits, il est possible de déplacer certaines portes quantiques de manière à ce qu'elles remplissent les zones d'inactivité des qbits.

Le recuit simulé cherche donc à maximiser la métrique globale visant à réduire le temps d'inactivité des qbits du circuit quantique. Les changements locaux autorisés par le processeur quantiques sont définis. Par exemple, de tels changements sont le remplacement de sous-circuits quantiques par un sous-circuit quantique équivalent diminuant le temps d'inactivité des qbits.

Une métrique locale, que la recherche locale et l'optimisation locale cherchent à maximiser, est de réduire le nombre de portes quantiques du circuit quantique.

Ainsi, la recherche locale et l'optimisation locale réécrivent des sous-circuits quantiques afin de réduire localement le nombre de portes quantiques.

Le recuit simulé effectue une transformation du circuit quantique obtenu à partir de ces sous-circuits quantiques afin de maximiser la métrique globale.

## Liste des documents cités

### Littérature non-brevet

À toute fin utile, le(s) élément(s) non-brevet(s) suivant(s) est (sont) cité(s) :

- nplcit1 : *Compiling SU(4) Quantum Circuits to IBM QX Architectures;*
- nplcit2 : *Rule-based optimization of reversible circuits.*

## Revendications

**1.** Méthode exécutée par ordinateur de développement d'un procédé de compilation d'un circuit quantique pour un processeur quantique, comprenant :

    - une étape de sélection :

        * d'un circuit quantique,
        * d'un processeur quantique pour une exécution du circuit quantique,
        * d'un jeu de portes quantiques exécutables sur le processeur quantique sélectionné, en fonction du processeur quantique sélectionné,
        * d'une métrique d'optimisation visant à réduire un nombre de portes quantiques global du circuit,
        * une métaheuristique sélectionnée parmi un recuit simulé, un algorithme génétique ou une descente de gradient,

- une implémentation du procédé de compilation comprenant d'abord :

* une étape de division du circuit quantique sélectionné en sous-circuits quantiques,
* une première étape de réécriture des sous-circuits quantiques comprenant des portes quantiques non exécutables par le processeur quantique sélectionné de manière à ce qu'ils comprennent uniquement des portes quantiques exécutables par le processeur quantique sélectionné,
* une deuxième étape de réécriture des sous-circuits quantiques, par la métaheuristique sélectionnée, de manière à obtenir des sous-circuits quantiques comprenant des portes quantiques exécutables par le processeur quantique sélectionné améliorant la métrique d'optimisation sélectionnée,
* une étape de regroupement des sous-circuits quantiques en un circuit quantique exécutable par le processeur quantique sélectionné,
* une étape de détermination, par la métaheuristique sélectionnée, si les sous-circuits quantiques regroupés sont optimaux, c'est-à-dire qu'un score associé au circuit quantique regroupé atteint un seuil prédéterminé ou qu'un nombre d'itérations maximal est atteint ; et si les sous-circuits quantiques regroupés ne sont pas optimaux, réitérer la deuxième étape de réécriture, l'étape de regroupement et l'étape de détermination ;

- une étape d'implémentation du procédé de compilation comprenant ensuite :

* une étape de détermination d'une implémentation des qbits logiques sur les qbits physiques du processeur quantique sélectionné, qui insère des portes quantiques de permutation pour réduire, par une recherche et une optimisation locales, le nombre de portes quantiques inefficaces et qui réduit, par l'application de la métaheuristique sélectionnée, le nombre de portes quantiques de permutation de valeur entre deux qbits physiques à insérer dans le circuit quantique pour que toutes les portes quantiques du circuit quantique soient, c'est-à-dire restent ou deviennent, des portes quantiques efficaces, une porte quantique efficace étant une porte quantique n'agissant que sur des qbits physiques voisins, une porte quantique inefficace étant une porte quantique agissant sur au moins deux qbits physiques non voisins.

2. Méthode de développement d'un procédé de compilation d'un circuit quantique pour un processeur quantique selon la revendication 1, dans laquelle l'étape de détermination d'une implémentation des qbits logiques sur les qbits physiques du processeur quantique sélectionné comprend :

- une boucle d'itérations comprenant successivement :

* une étape de simulation d'une implémentation donnée des qbits logiques sur les qbits physiques du processeur quantique,
* une étape de détection, dans le circuit quantique, de la ou des portes quantiques inefficaces,
* une étape d'estimation du nombre de portes quantiques de permutation de valeur entre deux qbits physiques à insérer dans le circuit quantique pour que toutes les portes quantiques du circuit quantique soient, c'est-à-dire restent ou deviennent, des portes quantiques efficaces,
* une étape de rétroaction, par l'intermédiaire de la métaheuristique sélectionnée, entraînant une nouvelle étape de simulation en fonction du nombre de portes quantiques de permutation de valeur entre deux qbits physiques estimées, jusqu'à atteindre, lorsque toutes les portes quantiques sont efficaces :

° soit un seuil minimal du nombre de portes quantiques estimées de permutation de valeur entre deux qbits physiques,
° soit un seuil maximal d'itérations dans la boucle.

3. Méthode de développement d'un procédé de compilation d'un circuit quantique pour un processeur quantique selon la revendication 2, dans laquelle :

- le seuil maximal d'itérations dans la boucle est prédéterminé en fonction au moins du processeur quantique et/ou du circuit quantique sélectionnés.

**Patentansprüche**

1. Computerausgeführte Methode zur Entwicklung eines Verfahrens zur Kompilierung einer Quantenschaltung für einen Quantenprozessor, umfassend:

- einen Schritt des Auswählens:

* einer Quantenschaltung,
* eines Quantenprozessors zur Ausführung der Quantenschaltung,
* eines Satzes von Quantengattern, die auf dem gewählten Quantenprozessor ausführbar sind, in Abhängigkeit von dem gewählten Quantenprozessor,
* einer Optimierungsmetrik zur Reduzierung einer Gesamtanzahl von Quantengattern der Schaltung,
* einer Metaheuristik, die aus Simulated Annealing, einem genetischen Algorithmus oder einem Gradientenabstieg gewählt wird,

- eine Implementierung des Kompilierungsverfahrens, die zunächst umfasst:

* einen Schritt der Unterteilung der gewählten Quantenschaltung in Unter-Quantenschaltungen,
* einen ersten Schritt des Umschreibens der Quantenunterschaltungen, die Quantengatter umfassen, die von dem gewählten Quantenprozessor nicht ausführbar sind, so dass sie nur Quantengatter umfassen, die von dem gewählten Quantenprozessor ausführbar sind,
* einen zweiten Schritt des Umschreibens der Quantenunterschaltungen durch die gewählte Metaheuristik, um Quantenunterschaltungen zu erhalten, die vom gewählten Quantenprozessor ausführbare Quantengatter umfassen, die die gewählte Optimierungsmetrik verbessern,
* einen Schritt des Zusammenfassens der Quantenunterschaltungen zu einer Quantenschaltung, die von dem gewählten Quantenprozessor ausführbar ist,
* einen Schritt des Bestimmens durch die gewählte Metaheuristik, ob die zusammengefassten Quantenunterschaltungen optimal sind, d.h. ob ein mit der zusammengefassten Quantenschaltung verbundener Score einen vorbestimmten Schwellenwert erreicht oder ob eine maximale Anzahl von Iterationen erreicht wird; und wenn die zusammengefassten Quantenunterschaltungen nicht optimal sind, Wiederholen des zweiten Umschreibeschritts, des Zusammenfassungsschritts und des Bestimmungsschritts;

- einen Schritt zur Implementierung des Kompilierungsverfahrens, der dann Folgendes umfasst:

* einen Schritt des Bestimmens einer Implementierung der logischen QBits auf die physikalischen QBits des gewählten Quantenprozessors, die Permutations-Quantengatter einfügt, um durch lokale Suche und Optimierung die Anzahl der ineffizienten Quantengatter zu reduzieren, und die durch Anwendung der gewählten Metaheuristik die Anzahl der Quantengatter zur Permutation des Wertes zwischen zwei physikalischen QBits, die in den Quantenkreis eingefügt werden müssen, damit alle Quantengatter des Quantenkreises effiziente Quantengatter sind, d.h. bleiben oder werden, reduziert, wobei ein effizientes Quantengatter ein Quantengatter ist, das nur auf benachbarte physikalische QBits wirkt, und ein ineffizientes Quantengatter ein Quantengatter ist, das auf wenigstens zwei nicht benachbarte physikalische QBits wirkt.

2. Methode zur Entwicklung eines Verfahrens zur Kompilierung einer Quantenschaltung für einen Quantenprozessor nach Anspruch 1, wobei der Schritt zur Bestimmung einer Implementierung der logischen QBits auf die physikalischen QBits des gewählten Quantenprozessors umfasst:

- eine Iterationsschleife, die nacheinander umfasst:

* einen Schritt der Simulation einer gegebenen Implementierung der logischen QBits auf die physikalischen QBits des Quantenprozessors,
* einen Schritt der Erkennung des oder der ineffizienten Quantengatter in der Quantenschaltung,
* einen Schritt zur Schätzung der Anzahl von Quantengattern zur Permutation des Wertes zwischen zwei physikalischen QBits, die in den Quantenkreis eingefügt werden müssen, damit alle Quantengatter des Quantenkreises effiziente Quantengatter sind, d. h. bleiben oder werden,
* einen Rückkopplungsschritt über die gewählte Metaheuristik, der einen neuen Simulationsschritt in Abhängigkeit von der Anzahl der geschätzten Quantengatter zur Permutation des Wertes zwischen zwei physikalischen QBits bewirkt, bis man, wenn alle Quantengatter effizient sind, Folgendes erreicht:

∘ entweder einen minimalen Schwellenwert für die Anzahl der geschätzten Quantengatter zur Permutation des Wertes zwischen zwei physikalischen QBits,
∘ oder einen maximalen Schwellenwert für die Iterationen in der Schleife.

3. Methode zur Entwicklung eines Verfahrens zur Zusammenstellung einer Quantenschaltung für einen Quantenprozessor nach Anspruch 2, wobei:

- der maximale Schwellenwert für Iterationen in der Schleife wenigstens in Abhängigkeit von dem gewählten Quantenprozessor und/oder der gewählten Quantenschaltung vorbestimmt ist.

**Claims**

1. Method executed by computer for the development of a compilation process of a quantum circuit for a quantum processor, comprising:

   - a selection step:

      * of a quantum circuit,
      * of a quantum processor for an execution of the quantum circuit,
      * of a set of executable quantum gates on the selected quantum processor, based on the selected quantum processor,
      * of an optimization metric to reduce the global number of quantum gates of the circuit,
      * of a meta-heuristic selected from a simulated annealing, a genetic algorithm or a gradient descent,

   - an implementation of the compilation method comprising first:

      * a step of division of the selected quantum circuit into quantum sub-circuits,
      * a first step of re-writing of the quantum sub-circuits comprising quantum gates non-executable by the selected quantum processor so that they comprise only quantum gates executable by the selected quantum processor,
      * a second step of re-writing the quantum sub-circuits, by the selected meta-heuristic, in order to obtain quantum sub-circuits comprising quantum gates executable by the selected quantum processor, improving the selected optimization metric,
      * a step of regrouping the quantum sub-circuits into a quantum circuit executable by the selected quantum processor,
      * a step of determining, by the selected meta-heuristic, if the regrouped sub-circuits are optimal, i.e. that the score associated with the quantum circuit obtained attains a pre-determined threshold, or if the maximum number of iterations is obtained ; and if the regrouped sub-circuits are not optimal, reiterating the second step of re-writing, the step of regrouping and the step of determining ;

   - an implementation step of the compilation method comprising then:

      * a step of determining an implementation of logical qubits on the physical qubits of the selected quantum processor, which inserts quantum swap gates for reducing, by a local search and local optimization, the number of ineffective quantum gates and which reduces, with the application of the selected meta-heuristic, the number of quantum value swap gates between two physical qubits to be inserted into the quantum circuit so that all the quantum gates of the quantum circuit are, that is remain or become, effective quantum gates, an effective quantum gate being a quantum gate which acts only on the neighboring physical qubits, an ineffective quatum gate being a quantum gate which acts on at least two non-neighboring physical qubits.

2. Method for the development of a compilation process of a quantum circuit for a quantum processor according to claim 1, wherein the step of determining an implementation of logical qubits on the physical qubits of the selected quantum processor comprises:

   - an iteration loop successively comprising:

      * a step of simulation of a given implementation of the logical qubits on the physical qubits of the quantum processor,
      * a step of detecting, in the quantum circuit, the ineffective quantum gate(s),
      * a step of estimating the number of quantum value swap gates between two physical qubits to be inserted into the quantum circuit so that all of the quantum gates of the quantum circuit are, that is remain or become, effective quantum gates,

* a retroaction step, through the selected meta-heuristic, involving a new step of simulation based on the number of quantum value swap gates between two estimated physical qubits, until attaining, whereupon the quantum gates are effective:

° either a minimum threshold of the number of estimated quantum value swap gates between two physical qubits,
° or a maximum threshold of iterations in the loop.

3. Method for the development of a compilation process of a quantum circuit for a quantum processor according to claim 2 wherein:

- the maximum threshold of iterations in the loop is predetermined based on at least one among the selected quantum processor and/or the selected quantum circuit.

[Fig. 1]

FIG. 1

[Fig. 2a]

## FIG. 2a

Sélection de paramètres —S1

Division du circuit quantique en sous-circuits quantiques —S2

Première réécriture des sous-circuits quantiques pour qu'ils ne comprennent que des portes quantiques exécutables —S3

Obtention des sous-circuits réécrits —S4

Deuxième réécriture des sous-circuits quantiques pour qu'ils comprennent des portes quantiques exécutables réduisant le nombre de portes quantiques —S5

Regroupement de ces sous-circuits —S6

NON — Score de la métrique ou nombre d'itérations atteint ? —S7

OUI

Vers Fig. 2b

[Fig. 2b]

De Fig. 2a

Simulation de l'implantation des qbits logiques sur le qbits physiques du processeur quantiques — S8

Détection des portes quantiques inefficaces — S9

Insertion des portes quantiques de permutation pour que toutes les portes quantiques soient efficaces — S10

Transformation du circuit quantique par le circuit simulé — S11

S12

Nombre minimal de portes de permutation ou seuil maximal d'itérations atteint ?

NON

OUI

obtention du circuit quantique — S13

FIG. 2b

[Fig. 3]

## Algorithme 1 : Optimisation locale

changements_possibles : = list < gain, membre droit, membre gauche >

init(changements_possibles)

*while* changement_local_possible() :
      trier_par_gain_décroissant(changements_possibles)

      *for* membre_droit, membre_gauche in changements_possibles :
           remplacer(membre_gauche, membre_droit)

# FIG. 3

[Fig. 4]

# FIG. 4

[Fig. 5]

# FIG. 5

[Fig. 6]

FIG. 6

[Fig. 7]

FIG. 7

[Fig. 8]

FIG. 8

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **ALWIN ZULEHNER et al.** Compiling SU(4) Quantum Circuits to IBM QX Architectures. *CORR (ARXIV)*, 05 November 2018, vol. 1808.05661 (v2), 1-6
- **THOMAS HÄNER et al.** A software methodology for compiling quantum programs. *Quantum Science and Technology*, 21 February 2018, vol. 3 (2), 020501
- Quantum-assisted quantum compiling. **SUMEET KHATRI et al.** ARXIV.ORG. Cornell University Library, 201 Olin Library Cornell University, 02 July 2018
- Qubit Allocation for Noisy Intermediate-Scale Quantum Computers. **WILL FINIGAN et al.** ARXIV.ORG. Cornell University Library, 19 October 2018